(19) Europäisches Patentamt
European Patent Office
Office européen des brevets

(11) **EP 1 281 975 B1**

(12) **EUROPÄISCHE PATENTSCHRIFT**

(45) Veröffentlichungstag und Bekanntmachung des Hinweises auf die Patenterteilung:
**05.03.2008   Patentblatt 2008/10**

(51) Int Cl.:
***G01R 15/20*** *(2006.01)*

(21) Anmeldenummer: **02016112.1**

(22) Anmeldetag: **19.07.2002**

(54) **Sensoreinrichtung zur indirekten Strommessung**

Sensing device for indirectly measuring currents

Capteur de mesure indirecte de courants

(84) Benannte Vertragsstaaten:
**DE FR IT**

(30) Priorität: **01.08.2001   DE 10137700**
**20.06.2002   DE 10227561**

(43) Veröffentlichungstag der Anmeldung:
**05.02.2003   Patentblatt 2003/06**

(73) Patentinhaber: **SIEMENS AKTIENGESELLSCHAFT**
**80333 München (DE)**

(72) Erfinder: **Bangert, Joachim, Dr.**
**91052 Erlangen (DE)**

(56) Entgegenhaltungen:
**EP-A- 0 107 059          EP-A- 0 618 628**
**DE-A- 19 753 554          US-A- 5 686 838**

• **ANONYMOUS MAGNET ABC, [Online] 01 M{rz 2001, INTERNET, XP001167329 Gefunden im Internet: <URL:http://www.magnetfabrik.de/abc/ SERVICE .HTM> [gefunden am 2007-08-14]**

**Beschreibung**

Die Erfindung bezieht sich auf eine Sensoreinrichtung zur indirekten Strommessungen mit wenigstens einem elektrischen Leiterelement, das mittels Stromfluss' ein magnetisches Messfeld erzeugt, sowie mit wenigstens einem Sensor. Eine entsprechende Sensoreinrichtung ist z.B. aus dem Buch von E. Schrüfer "Elektrische Messtechnik", 6. Aufl., 1995, Hanser-Verlag München, Seiten 165 bis 168 zu entnehmen. Die Erfindung betrifft ferner die Verwendung einer solchen Sensoreinrichtung.

Eine indirekte Messung von elektrischen Strömen kann auf vielfältige Weise geschehen. Ströme, die in integrierten Bausteinen fließen, werden durch Bauelemente ausgewertet, deren physikalische Eigenschaften sich auf Grund der fließenden Ströme ändert. So ist z.B. der vorstehend erwähnten Literaturstelle eine potenzialfreie Messung eines Stromes zu entnehmen, bei der die Detektion des von dem Strom erzeugten Magnetfeldes als Messsignal ausgewertet wird. Hierzu wird der Strom durch die Wicklung eines Elektromagneten geschickt. Dessen magnetische Induktion wird bei mittels einer Hall-Sonde bestimmt. Bei einem konstanten Steuerstrom durch die Hall-Sonde ist die erfassbare Hall-Spannung ein Maß für den zu messenden Strom.

Eine solche Strommessung unter Verwendung von Hall-Sonden stößt jedoch praktisch auf große Schwierigkeiten. Auch bei verhältnismäßig hohen Stromstärken ist nämlich das einen stromdurchflossenen Leiter umgebende Magnetfeld immer noch so klein, dass nur sehr niedrige Hall-Spannungen auftreten. Man sieht sich deshalb z.B. gezwungen, mit dem zu messenden Strom einen definierten Magnetkreis zu erregen, um so eine wesentlich höhere magnetische Induktion in dem Luftspalt eines solchen Magnetkreises messen zu können. Abgesehen davon, dass entsprechende Messeinrichtungen verhältnismäßig voluminös sind, ist der diesbezügliche apparative Aufwand auch hoch. Außerdem ist eine Integration in eine mit der Silizium-Technologie kompatible Technologie kaum möglich.

Aus dem Buch "Sensors", Vol. 5 (Magnetic Sensors), VCR-Verlagsgesellschaft, D-6940 Weinheim (DE), 1989, Seiten 145 bis 147 sind verschiedene Sensoreinrichtungen zu entnehmen, welche den magnetostriktiven Effekt mit anderen physikalischen Effekten kombinieren. So ist z.B. ein Kraftsensor offenbart, der den magnetoresistiven Effekt und den Hall-Effekt ausnutzt. Hierzu wird in magnetoresistiven Teilen mittels eines konstanten Stromes ein magnetischer Fluss erzeugt, der unter Krafteinwirkung zu einer entsprechenden Flussänderung führt. Diese Flussänderung wird mit einem Hall-Element detektiert.

Darüber hinaus ist in dem vorstehend erwähnten Buch auch eine Sensoreinrichtung beschrieben, mit der ein magnetostriktiver Streifen mit einem piezoelektrischen Wandler verbunden ist. Der magnetostriktive Streifen wird von einem zu messenden DC-Feld magnetisiert. Die damit verbundene Längenänderung des Streifens wird mittels des piezoelektrischen Wandlers in ein elektrisches Messsignal umgewandelt.

Des Weiteren ist aus EP 0 107 059 A ein Stromsensor bekannt, bei dem zwischen zwei den Strom führenden Leitern ein piezoelektrisches Element angeordnet ist, dessen Signal als Stromsignal ausgewertet wird. Magnetfeld-Kraftsensoren sind beispielsweise aus der DE 197 53 554 A1 bekannt. Des Weiteren sind aus der US 5 686 838 A ein Sensor zur Magnetfeldmessung und aus der EP 0 618 628 B1 ein mechanischer Sensor bekannt.

Ausgehend vom Stand der Technik ist es, Aufgabe der vorliegenden Erfindung ist es, die Sensoreinrichtung mit den eingangs genannten Merkmalen dahingehend auszubilden, dass sie eine hohe Empfindlichkeit besitzt und mittels bekannter Verfahren in Schichttechnik, insbesondere Dünnfilmtechnik, herstellbar ist. Außerdem sollen bevorzugte Verwendungen einer solchen Sensoreinrichtung angegeben werden.

Die sich auf die Sensoreinrichtung beziehende Aufgabe wird erfindungsgemäß mit den in Anspruch 1 angegebenen Merkmalen gelöst. Vorteilhafte Ausgestaltungen der erfindungsgemäßen Sensoreinrichtung gehen aus den von Anspruch 1 abhängigen Sachansprüchen hervor. Spezifische Anwendungen der erfindungsgemäßen Sensoreinrichtung sind Gegenstand der Verwendungsansprüche.

Gegenstand der Erfindung ist eine Sensoreinrichtung zur indirekten Strommessung. Im Gegensatz zu bisherigen Stromsensoren wird in der erfindungsgemäßen Sensoreinrichtung nicht direkt das Magnetfeld des Stromes ausgewertet, sondern die Wirkung des Magnetfeldes auf ein anderes Magnetfeld über die Lorentz-Kraft. Hierzu wird vorwiegend die Kraft ausgenutzt, die insbesondere zwei stromführende Leiterteile aufeinander ausüben. Dabei ist wenigstens einer der Ströme der zu messende Strom, der in der Nähe eines anderen Stromleiters bzw. Referenzelementes vorbeiführt. Zwischen diesen Leitern befindet sich der Kraftsensor, dessen Eigenschaften sich auf Grund der Kräfte ändern.

Im Rahmen der Erfindung ist es auch möglich, dass das als Referenzelement wirkende Leiterelement von einem permanentmagnetischen Element gebildet wird, von dessen Magnetfeld das Messstromleiterelement abgestoßen bzw. angezogen wird. Die Kraftänderung führt zu einer Richtungsänderung der Magnetisierung in dem magnetostriktiven Teil, die eine entsprechende Änderung eines an dem Kraftsensor in bekannter Weise abnehmbaren elektrischen Messsignals hervorruft.

Die spezielle Nutzung der Wechselwirkung zwischen einem Magnetfeld und magnetischen Schichten erlaubt ganz neue Detektoren. So können beispielsweise durch weitere Leiter zusätzlich magnetische Hintergrundfelder erzeugt werden, die die Magnetisierung in dem Kraftsensor der Sensoreinrichtung in einer bestimmten Art und Weise vorspannen.

Es tritt dann eine Kennlinienverschiebung auf. Auf diese Weise lassen sich z.B. Stellwertschalter oder Elemente mit diodenartigem Verhalten, die eine Richtungsabhängigkeit des Stromes zeigen, realisieren. Dieses Verhalten kann durch Abschalten des Stromes abgestellt werden. Durch dauermagnetische Teile kann dieses Verhalten permanent eingestellt werden.

Bei der Sensoreinrichtung nach der Erfindung wird die Kraft zwischen dem Leiterelement und dem Referenzelement in eine elastische mechanische Dehnung des Materials des Kraftsensors überführt, das zur Auswertung dieser Kraft auf Grund magnetostriktiver Effekte herangezogen wird. Vorteilhaft hängt dabei die entstehende Kraft linear von den Strömen ab. Diese Kraft ist auch groß genug, um magnetostriktive Materialien zu dehnen oder zu stauchen. Es ergibt sich so eine sehr gute Skalierbarkeit des Messsignals. Da außerdem die ausgenutzten physikalischen Effekte unabhängig von der geometrischen Größe des Kraftsensors sind, kann dieser insbesondere in Dünnschichttechnik mit sehr geringen Abmessungen ausgebildet werden.

So ist es als besonders vorteilhaft anzusehen, dass die Umwandlungsmittel wenigstens ein dem magnetostriktiven Teil zugeordnetes magnetoresistives Element sind. Dabei können vorzugsweise diese Umwandlungsmittel ein magnetoresistives Mehrschichtensystem sein, in das mindestens eine den magnetostriktiven Teil bildende Schicht integriert ist. D.h., das magnetostriktive Material weist dabei gleichzeitig zwei Eigenschaften auf, und zwar ist es - magnetostriktiv und weist außerdem eine Spinpolarisation auf.

Das magnetoresistive Element mit einem derartige Mehrschichtensystem kann insbesondere vom AMR-Typ oder Teil eines GMR- oder TMR- oder XMR-Typs sein.

Alternativ zum magnetoresistivem Mehrschichtensystem kann der magnetostriktive Teil des Kraftsensors in vorteilhaft einfacher Weise auch durch eine magnetoresistive Einzelschicht gebildet sein.

Mit der erfindungsgemäßen Ausgestaltung der Sensoreinrichtung lassen sich verschiedene Verwendungen in der Messtechnik und der Datenverarbeitung realisieren. Dabei kann die Einrichtung vorzugsweise als Strommesser mit einstellbarer Kennlinie, aber auch als eine Vorstufe zu einem digitalen Logikelement oder als ein digitaler Stromwandler ausgebildet werden.

Zur weiteren Erläuterung der Erfindung wird nachfolgend auf die Zeichnung Bezug genommen, an Hand derer Ausführungsbeispiele von Sensoreinrichtungen schematisch veranschaulicht sind.

Es zeigen

- die Figur 1 den prinzipiellen Aufbau eines Kraftsensors für eine Sensoreinrichtung,
- die Figuren 2 bis 5 jeweils einen Kraftsensor im kraftfreien Zustand (Teil a) und unter Einwirkung einer Kraft (Teil b),
- die Figur 6 ein Diagramm bezüglich des Magnetostriktions-Koeffizienten in Abhängigkeit von der Schichtdicke einer magnetostriktiven Schicht und
- die Figuren 7 bis 12 spezielle Ausführungsformen von Sensoreinrichtungen.

In den Figuren sind sich entsprechende Teile mit denselben Bezugszeichen versehen.

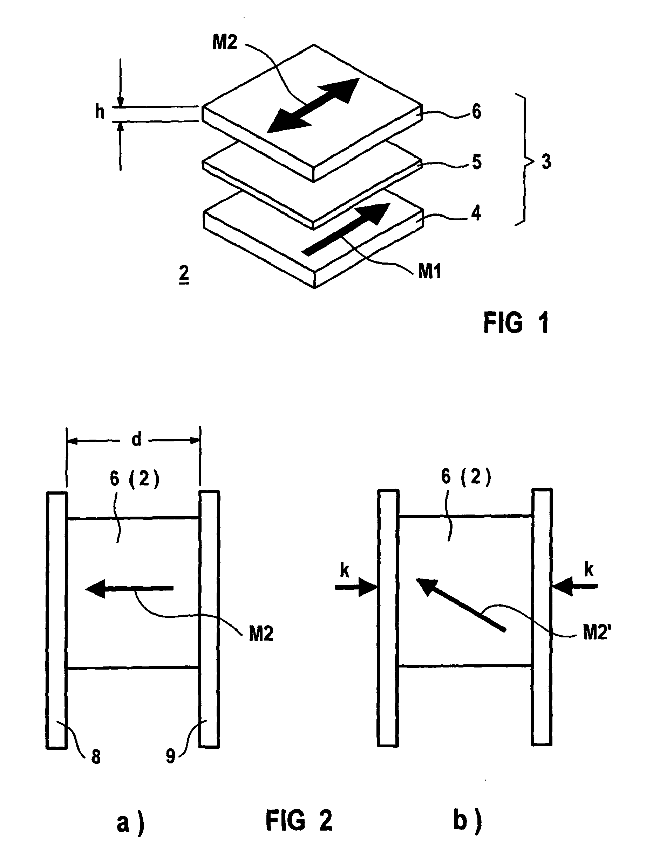

Figur 1 zeigt in Schrägansicht eine Ausführungsform eines Kraftsensors 2 für eine Sensoreinrichtung nach der Erfindung in Dünnschichttechnik. Der Kraftsensor 2 umfasst dabei ein Mehrschichtensystem 3, das in seiner Grundform eine magnetische Basisschicht 4, eine nicht-magnetische Zwischenschicht 5 sowie eine weitere magnetische Schicht 6 mit einer Schichtdicke oder -höhe h enthält. In der Basisschicht 4 ist eine Magnetisierung M1 fest eingeprägt, während eine Magnetisierung M2 in der weiteren Schicht 6 durch eine Krafteinwirkung veränderbar ist. Die Basisschicht 4 ist deshalb vergleichsweise magnetisch härter als die weitere Schicht 6. Da die Basisschicht ein magnetisches Hintergrundfeld (sogenanntes "Biasfeld") erzeugt, wird sie vielfach auch als Biasschicht bezeichnet. Da die demgegenüber magnetisch weichere Schicht 6 im Wesentlichen nur die bzgl. einer äußeren Kraftwirkung empfindliche Schicht ist, kann sie deshalb als eine Detektion- oder Messschicht angesehen werden. Die Basisschicht kann in an sich bekannter Weise auch durch ein Schichtsystem gebildet sein, das z.B. einen künstlichen Antiferromagneten darstellt (vgl. WO 94/15223). Vorzugsweise kann das Mehrschichtensystem 3 giant-magnetoresistiv (sogenanntes "GMR-System"), tunnelmagnetoresistiv (sogenanntes "TMR-System") oder colossalmagnetoresisitv (sogenanntes "CMR-System") sein und dementsprechend in bekannter Weise ein GMR- oder TMR- oder XMR-System mit einem erhöhten magnetoresistiven Effekt bilden (vgl. z.B. den Band "XMR-Technologien"-Technologieanalyse: Magnetismus; Bd. 2, VDI-Technologiezentrum "Physikalische Technologien", Düsseldorf (DE), 1997, Seiten 11 bis 46). Je nach gewähltem System besteht die Zwischenschicht 5 dann aus einem metallischen Material wie z.B. Cu (z.B. für ein GMR-System) oder aus einem isolierenden Material wie $Al_2O_3$ (z.B. für ein TMR-System).

Gemäß der Erfindung soll mit der Messschicht 6 ein magnetostriktiver Teil des Kraftsensors 2 ausgebildet sein, der bei fehlendem Kraft- bzw. Messfeld eine vorbestimmte Ausrichtung seiner Magnetisierung M2 zeigt. Die Schicht 6 besteht deshalb aus einem der bekannten magnetostriktiven Materialien.

Alternativ ist auch möglich, dass die Schicht 4 auf eine Krafteinwirkung in umgekehrter Weise regiert wie die Schicht 6.

Aus den Aufsichten der Figur 2 auf den Kraftsensor 2 nach Figur 1 bzw. auf dessen oberste Messschicht 6 ist die Änderung der Magnetisierung M2 in dem magnetostriktiven Material in Abhängigkeit von einer äußeren Druckkraft k veranschaulicht. Teil a der Figur zeigt die Ausrichtung dieser Magnetisierung M2 bei fehlender Kraftwirkung auf die zwischen zwei Elementen 8 und 9 kraftschlüssig eingespannte magnetostriktive Messschicht 6 des Sensors 2 mit einer Ausdehnung (Abstand) d zwischen den zwei Elementen. Das Element 9 kann dabei als ein "Referenzelement" zu dem Element 8 angesehen werden. Denn dieses Element 9 ruft zu dem von dem Element 8 erzeugten Kraft eine diese überlagernde bzw. mit dieser in Wechselwirkung tretenden Gegen- oder Referenzkraft hervor, die also eine Referenz oder Basis für die auf dem Sensor 2 einwirkend Kraft darstellt. Wird, wie im Teil b der Figur angedeutet ist, das Material der Schicht 6 unter Einwirkung der Kraft k gestaucht, so erzeugt der Druck in dem Material eine Anisotropie parallel zu der Ausdehnungsrichtung der Elemente 8 und 9 bzw. senkrecht zur Abstandslinie zwischen diesen Elementen. Dies hat zur Folge, dass die Magnetisierung in diese Richtung gedreht wird. Die so gedrehte Magnetisierung ist in Figur 2, Teil b, mit M2' bezeichnet. Die Drehung der Magnetisierung wird mit bekannten Mitteln, die insbesondere in der Messtechnik unter Verwendung von magnetostriktiven und/oder magnetoresistiven Sensoren geläufig sind, in ein eindeutig damit korreliertes elektrisches Messsignal umgewandelt (vgl. z.B. die genannte WO94/15223).

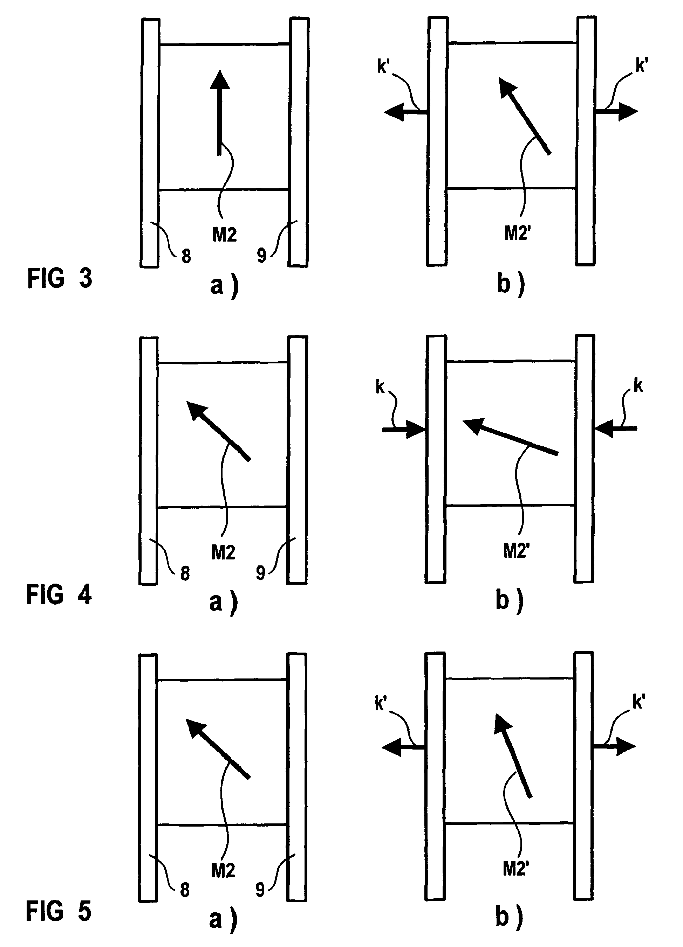

Wie aus den Figuren 3 bis 5 in Figur 2 entsprechender Darstellung hervorgeht, kann selbstverständlich die Ausgangslage der Magnetisierung M2 in der magnetostriktiven Messschicht 6 des Kraftsensors 2 auch in verschiedene andere Richtungen als gemäß Figur 2 weisen. Je nach Krafteinwirkung erfolgt auch hier eine Drehung der Magnetisierung. Gemäß Figur 3 wird das Material durch eine Zugkraft k' gedreht, so dass in dem magnetostriktiven Material eine Anisotropie in der Zugrichtung erzeugt wird. Dadurch dreht sich die Magnetisierung (M2 in M2') in diese Richtung. Gemäß den Figuren 4 und 5 kann eine ursprünglich schräg (z.B. um 45˚) bezüglich der Elemente 8 und 9 gerichtete Magnetisierung M2 durch eine Druckkraft k (Figur 4) oder eine Zugkraft k' (Figur 5) entsprechend ausgelenkt werden.

Bei einer mechanischen Dehnung von z.B. epsilon = 0,05 % kann bereits eine deutliche Änderung der Magnetisierungsrichtung in einer magnetostriktiv empfindlichen Schicht erwartet werden. In einem magnetoresistiven Element (z.B. vom GMR- oder TMR-Typ) kann diese Änderung eine Änderung des Widerstandswertes von z.B. 10 % verursachen. Damit ergibt sich eine rechnerische "figure of merit" von F = 200. Zum Vergleich haben bekannte Dehnungsschichten bzw. piezoelektrische Schichten ein $F_{DMS}$ = 2 bzw. $F_{Piezo}$ = 150.

Bei den vorstehenden Ausführungsbeispielen gemäß den Figuren 2 bis 5 wurde davon ausgegangen, dass die Kraftsensoren mit Messschichten mit positiver Magnetostriktion realisiert sind. Ebenso gut lassen sich auch Schichten mit negativer Magnetostriktion verwenden. Für solche Schichten muss z.B. der Messstrom $I_m$ umgedreht werden; d.h., dann ist die Wirkung der Kraft entgegengesetzt, wobei die magnetostriktive Wirkung unverändert bleibt.

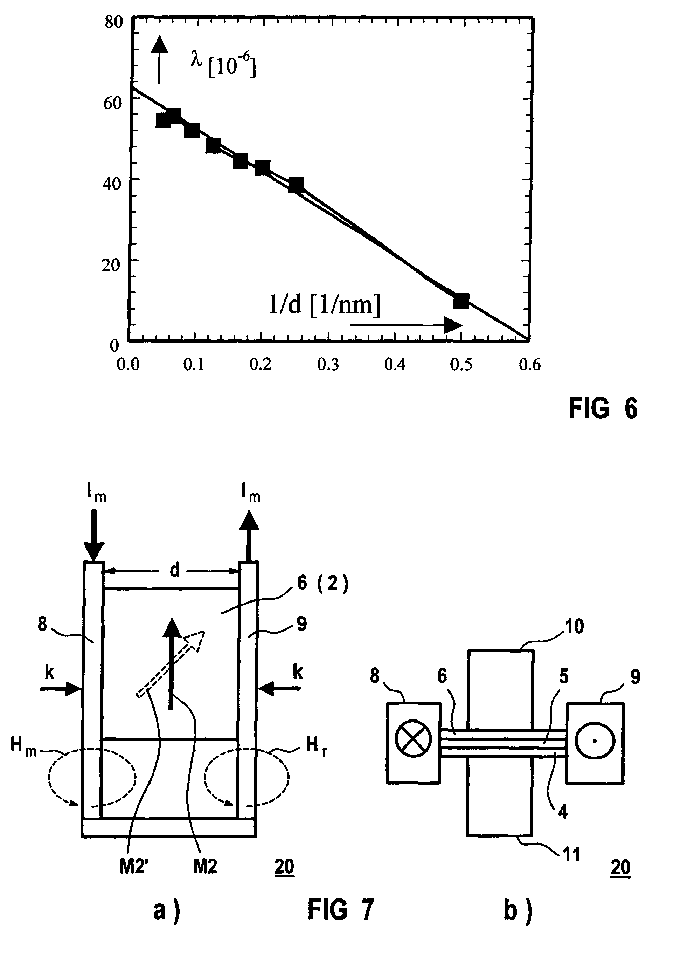

Für eine Realisierung der magnetostriktiven Schicht sind vorteilhaft Co und/oder Ni-haltige Magnetschichten, die einen hohen Magnetostriktions-Koeffizienten $\lambda$ aufweisen. Charakteristisch für viele Materialien ist die Abhängigkeit des Magnetostriktionskoeffizienten von der Zusammensetzung (z.B. in Atom-% gemessen) und auch von der Schichtdicke. So ist z.B. für $Co_{100}$ das $\lambda$ negativ, während für $Co_{95}Fe_5$ eine nahezu Magnetostriktionsfreiheit beobachtet wird. Demgegenüber weist $CO_{50}Fe_{50}$ ein positives Maximum in der Magnetostriktion auf. Hier ist jedoch die Schichtdicke d entscheidend für die absolute Größe des Magnetostriktionskoeffizienten $\lambda$. Eine entsprechende Abhängigkeit geht aus dem Diagramm der Figur 6 hervor, in der auf der Abszisse der reziproke Wert der Schichtdicke d und auf der Ordinate der Magnetostriktions-Koeffizient $\lambda$ aufgetragen sind. Zur Theorie der Magnetostriktion im amorphen und polykristallinen Materialien sei auf "Journal of Magnetism and Magnetic Materials", Vol. 69 (1987), Seiten 79 bis 98 verwiesen. Ausführungen zur Magnetostriktion von amorphen Selten-Erd-Fe-Legierungen bzw. Co-Ni-Legierungen gehen auch aus dem genannten Journal, Vol. 79 (1989), Seiten 358 bis 364 und Vol. 61 (1986), Seiten 390 bis 394 hervor.

Abweichend von einer Ausbildung des Kraftsensors 2 als Mehrschichtensystem, welches einen erhöhten magnetoresistiven Effekt zeigt, kann der Kraftsensor für die erfindungsgemäße Sensoreinrichtung auch durch eine einzige Schicht ausgebildet sein. Diese Schicht zeigt den sogenannten AMR-Effekt (vgl. den genannten Band "XMR-Technologien") Entscheidend ist nämlich nur die magnetostriktive Eigenschaft der Schicht oder des Schichtensystems, wobei eine von der Krafteinwirkung abhängige Ausrichtung der Magnetisierung detektiert und ausgewertet wird.

Bei den nachfolgend an Hand der Figuren 7 bis 12 angedeuteten Ausführungsformen wird von Kraftsensoren ausgegangen, deren Messschicht 6 eine Fläche von etwa 1,5 x 1,5 $\mu m^2$ (mit "x" = Multiplikationszeichen) aufweisen. Die Dicke der (Leiter-)Elemente 8 und 9 wird durch die Technologie vorgegeben und liegt im Bereich weniger 10 bis einiger 100 nm. Die Dicke der aktiven magnetoresistiven Messschicht liegt im Bereich weniger nm.

Für eine energiesparende Version einer Sensoreinrichtung gemäß Figur 7 bietet es sich an, einen Messstrom $I_m$ außerhalb des Kraftsensors 2 in einem Bogen zu führen und damit denselben Strom mit sich selbst wechselwirken zu lassen. Dabei können durch die Wahl der Stromrichtung attraktive (stauchende) oder repulsive (dehnende) Kräfte k bzw. k' erzielt werden.

Zur Abschätzung des Effektes sei angenommen, dass auf einen mit einem Strom I (= zu messender Strom $I_m$) durchflossenen Leiter in einem Magnetfeld B die Kraft F=k pro Längeneinheit 1 des Leiters

$$F/l = I \times B,$$

wirkt, wobei hier alle Vektoren als Beträge angenommen sind. Die Kraft F zwischen zwei Leitern mit den Strömen I1 und I2 und dem Abstand d ist dann

$$F/l = (\mu/2\pi) \times (I1 \times I2/d)$$

(mit "x" = Multiplikationszeichen).

Gemäß einem konkreten Beispiel für die Kraftwirkung gemäß vorstehender Formel sei angenommen:

$\mu_r = $  10 (für das verwendete magnetische Material)
I1 =  I2 = $I_m$ (in A)
d =  1 $\mu$m (anzustrebende Größenordnung der Kraftsensorausdehnung)
h =  5 nm (Schichtdicke der kraftsensitiven Sensorschicht, auf die die Kraft wirkt)

Kraft/m Leiterelementlänge: $2N/m/A^2$

Druck auf die Schicht/Meter Sensorlänge: $4TPa/m/A^2$ Zum Vergleich: Der Druck auf einen freigelegten Steg aus $SiO_2$ mit einer Breite von 1 $\mu$m beträgt maximal ca. 100 kPa pro m Steglänge (= Länge des Leiterelementes). Ein solcher Wert ist im Allgemeinen ausreichend für die praktische Nutzung des magnetostriktiven Effektes. Für einen nicht weitgehend freiliegenden oder gelagerten Sensor wird der Druck durch die Lorentzkraft durch den Gegendruck des umgebenden Materials geschwächt; es lässt sich allerdings immer noch ein Effekt nachweisen. Für ein anisotropiefreies, magnetisches und magnetostriktives Material verursachen jedoch schon geringste Druckunterschiede einen maximalen Effekt.

Figur 7 zeigt eine entsprechende Ausführungsform einer erfindungsgemäßen Sensoreinrichtung 20 in Aufsicht (Teil a der Figur) und im Querschnitt (Teil b der Figur). Der Kraftsensor 2 bzw. seine magnetostriktive Messschicht 6 ist dabei zwischen einem ersten, ein Leiterelement 8 bildenden und einem zweiten, ein Referenzelement 9 bildenden Teil eines Stromleiters in kraftschlüssiger Verbindung mit diesen Leiterteilen angeordnet. Seine Ausdehnung d stellt dabei den Abstand zwischen den beiden Elementen 8 und 9 dar. D.h., bei dieser Ausführungsform wird das Referenzelement 9 durch einen Teil desselben Leiters mit jedoch entgegengesetzter Stromflussrichtung gebildet. Der Strom $I_m$ durch das Leiterelement 8 ruft dabei ein Magnetfeld bzw. Messfeld $H_m$ hervor, das mit dem von dem Referenzelement 9 hervorgerufenen Magnetfeld bzw. Referenzfeld $H_r$ wegen des geringen Abstandes d zwischen den beiden Elementen 8 und 9 in Wechselwirkung tritt und so eine gegenseitige Kraftwirkung zwischen den beiden Elementen hervorruft.

Gegebenenfalls ist es ferner auch möglich, das Magnetfeld $H_m$ des Messstromes $I_m$ gleichzeitig für die magnetostriktive Kraftwechselwirkung und eine Auslenkung der Magnetisierungsrichtung in den magnetischen Schichten einzusetzen.

Normalerweise sollte der Messstrom nicht mit der Magnetisierung in einer der Schichten (z.B. von XMR-Mehrschichtsystemen oder der einzigen Schicht eines AMR-Typs) wechselwirken. Als Alternative sei hier sowohl eine Kraft als auch eine "klassische XMR-Sensorabhängigkeit betrachtet, d.h. eine gleichzeitige Wirksamkeit des magnetischen Feldes mit zwei unterschiedlichen magnetischen Effekten (XMR und Magnetostriktion). Eine Anordnung des Kraftsensors zwischen dem stromführenden Leiterelement und dem Referenzelement ist dann derart möglich, dass er zusätzlich empfindlich für senkrecht hindurchtretende Magnetfelder ist. Ein Beispiel ist ein GMR-Sensor vom CPP-Typ (Current Perpendicular to Plane; vgl. WO 94/15223). Hierbei liegen die Flachseite des Sensors und die felderzeugenden Elemente in derselben oder in parallelen Ebenen. Dabei sollte als die mindestens eine magnetfeldsensitive Schicht eine solche eingesetzt werden, die sich senkrecht magnetisieren lässt, aber eine Vorzugsrichtung der Magnetisierung in der Ebene aufweist.

Zu einer technischen Realisierung der in Figur 7 (Teil a) angedeuteten Ausführungsform einer Sensoreinrichtung 20 bedarf es nicht unbedingt einer flächigen Ausbildung. Denn für Materialien mit einer magnetostriktiven Empfindlichkeit in einer anderen Richtung kann man auch entsprechend gedrehte Aufbauten realisieren. Für die nachfolgenden Ausführungsformen von erfindungsgemäßen Sensoreinrichtungen sei jedoch die Annahme der magnetostriktiven Empfindlichkeit in einer Waferebene getroffen. Damit ergibt sich die folgende, prinzipielle Anordnungen im Querschnitt der Figur 7, Teil b: Gemäß dieser Figur sollte die magnetostriktive Messschicht 6 so zwischen zwei Elementen 8 und 9 liegen, dass die entstehenden Feldkomponenten nur senkrecht auftreten. Damit lassen sich magnetische Wechselwirkungen mit magnetischen Schichten des Kraftsensors 2 vermeiden.

Die Ausführungsform nach Figur 7, Teil b, ist besonders für den TMR- und den senkrechten GMR-Effekt mit sogenannter CIP-Kontaktierung (vgl. WO 94/15223) günstig, da hier das Signal durch einen Stromfluss von oben nach unten oder umgekehrt ausgewertet werden kann. Der Kraftsensor braucht dabei keinen Kontakt zu den stromführenden Elementen zu haben. Für Schichten, deren Widerstandsänderung in einer Waferebene ausgelesen werden muss, wie z.B. für GMR-Systeme mit CIP-Kontaktierung (vgl. WO 94/15223) oder AMR-Schichten kann das Signal über die einzelnen Leiter abgegriffen werden. Alternativ können auch gemäß Figur 7b zusätzlich Anschlussleiter 10 und 11 aus metallischem oder halbleitendem Material parallel zwischen den Elementen 8 und 9 verlaufen. Mit diesen Anschlussleitern sind die Sensorsignale des z.B. als GMR-Mehrschichtensystem mit Messschicht 6, Zwischenschicht 5 und Basisschicht 4 ausgebildeten Kraftsensors 2 abzunehmen.

Besonders vorteilhaft ist die Leiteranordnung nach Figur 7 für digitale Stromwandler. Die Wirkung des Stromes mit sich selbst führt nämlich zu einer quadratischen Wechselwirkung. Bei unterschiedlichen Strompegeln für die beiden Logikzustände (z.B. 4 mA: LOW; 20 mA: HIGH) wird ein besonders starker Unterschied im Signal erzielt. Der fließende Strom kann ohne signifikante Rückwirkung wieder verwendet werden.

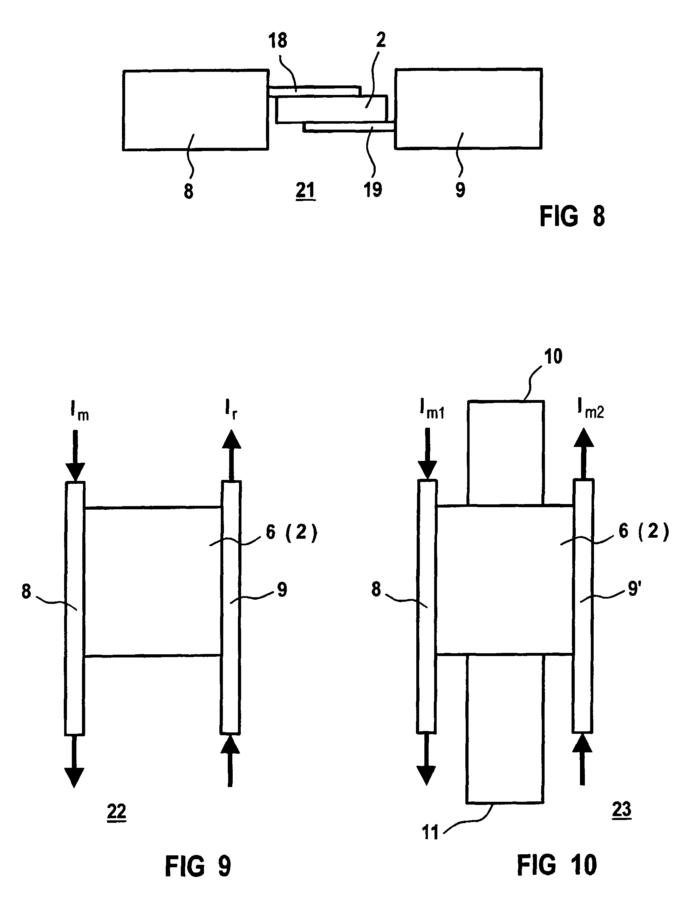

Ist es schaltungstechnisch realisierbar, kann das Signal auch über die Leiterelemente 8 und 9 selbst abgegriffen werden. Dazu wird von jeder Seite das Schichtsystem des Kraftsensors 2 von oben bzw. unten kontaktiert. Eine entsprechende Ausführungsform einer Sensoreinrichtung 21 mit Kontaktierungsteilen 18 und 19 ihrer Elemente 8 und 9 geht aus dem Querschnitt der Figur 8 hervor.

Die in Figur 9 in Aufsicht dargestellte Ausführungsform einer Sensoreinrichtung 21 unterscheidet sich von der Sensoreinrichtung 20 nach Figur 7 lediglich dadurch, dass ihr Referenzelement 9' durch einen Stromleiter gebildet ist, der getrennt vom Stromkreis des Leiterelementes 8 ist und einen Referenzstrom $I_r$ führt. Für eine solche Sensoreinrichtung mit einstellbarer Empfindlichkeit ihres Kraftsensors ist nämlich der Einsatz eines solchen, von dem Messstrom $I_m$ unabhängigen Referenzstroms $I_r$ vorteilhaft. Damit wird ein lineares Verhalten des Sensors erreicht, dessen Kennlinie wie ein Messbereich einstellbar ist. Es können sowohl positive als auch negative Ströme angelegt werden. Auf diese einfache Weise lässt sich ein invertierendes Verhalten erreichen. Wird nämlich kein (Referenz- oder Mess-)Strom angelegt, so ist die Sensoreinrichtung passiv geschaltet, d.h. inaktiv. Damit kann die Sensoreinrichtung auch als Vorstufe zu einem Logikelement genutzt werden, z.B. als AND-Gatter. Die Möglichkeit zur Passivschaltung der Wechselwirkung erlaubt eine Abtastung des Messstroms $I_m$ mit einem Abtastimpuls auf dem Referenz(leiter)element 9'. Die Amplitude und die Anzahl der aufintegrierten Messimpulse bestimmt die Empfindlichkeit bzw. die Genauigkeit. Durch ein entsprechendes Puls/Pause-Verhältnis kann unter anderem auch der Leistungsverbrauch gesenkt werden. Zur Auswertung von kontinuierlichen Messströmen $I_m$ ist ein sinusförmiger Strom als Referenzgröße günstig weil dann die Magnetostriktion sehr empfindlich z.B. mit einem Lock-in-Verstärker ausgelesen werden kann. Der Messstrom kann dann bei Bedarf weiterverarbeitet werden.

Bei der in Aufsicht gezeigten Ausführungsform einer Sensoreinrichtung 23 nach Figur 10 kann durch das Referenzelement 9' ein zweiter Messstrom $I_{m2}$, der unabhängig von dem Messstrom $I_{m1}$ durch das (erste) Leiterelement 8 wählbar ist. Die Kennlinie der Kraftwechselwirkung erlaubt dann den Einsatz der Sensoreinrichtung als Mischer für elektrische Ströme. So können z.B. Frequenztransformationen durchgeführt werden. Beide Messströme $I_{m1}$ und $I_{m2}$ können weiterverarbeitet werden. Die Figur zeigt außerdem mögliche Anschlussleiter 10 und 11 für den Kraftsensor 2 der Einrichtung 23. Der Kraftsensor kann auch hier durch ein magnetoresistives Mehrschichtensystem, durch eine einzelne magnetoresistive Schicht gebildet sein.

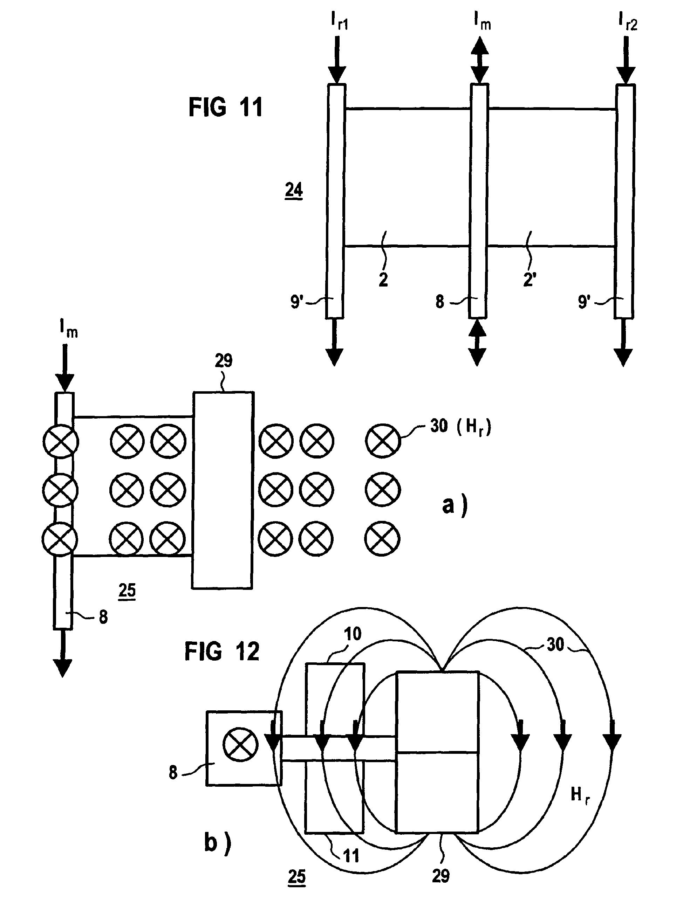

Selbstverständlich kann die Sensoreinrichtung nach der Erfindung auch mehrere Kraftsensoren aufweisen, die durch einen Messstrom $I_m$ unter Druck oder Zug zu setzen sind. Figur 11 zeigt in Aufsicht eine entsprechende Ausführungsform einer Sensoreinrichtung 24, die symmetrisch zu einem von einem Messstrom $I_m$ durchflossenen Leiterelement 8 zwei Kraftsensoren 2 und 2' aufweist. An jedem Kraftsensor ist auf dessen dem Leiterelement 8 gegenüberliegender Außenseite jeweils kraftschlüssig ein einen Referenzstrom $I_{r1}$ bzw. $I_{r2}$ führendes Referenzelement 9' angeordnet. Bei dieser Ausführungsform kann das Magnetfeld eines Leiters und damit der Effekt durch eine Spulenanordnung, z.B. durch eine Schleifenbildung des Referenzstromleiters 9' verstärkt werden. Ist der magnetostriktive Effekt für Stauchung und Dehnung identisch oder lässt sich entsprechend linearisieren, z.B. durch eine 45°-Einstellung der Magnetisierung M1 im Ruhezustand, so bietet sich die in Figur 11 gezeigte Sensoreinrichtung 24 an, in der eine Art Brücke mit einem Leiter in der Mitte und gleichen Stromrichtungen $I_{r1}$ und $I_{r2}$ in den Referenz(leiter)elementen 9' außen realisiert sind. Damit verdoppelt sich nämlich das Messsignal.

Bei den Ausführungsformen der Sensoreinrichtungen 20 bis 24 nach den Figuren 7 bis 11 wurde davon ausgegangen, dass mit wenigstens einem stromdurchflossenen Referenzelement 9 bzw. -leiter ein magnetisches Gegenfeld $H_r$ erzeugt wird, das mit dem von einem Messstrom $I_m$ durchflossenen Leiterelement 8 erzeugten Magnetfeld $H_m$ in Wechselwirkung tritt. Selbstverständlich kann das Magnetfeld $H_r$ des Referenzelementes auch durch ein Element aus einem hartmagnetischen, dauermagnetischen Material erzeugt werden. Figur 12 zeigt in einer der Figur 7 entsprechenden Darstellung eine entsprechende Sensoreinrichtung 25 in Aufsicht (Teil a der Figur) bzw. im Querschnitt (Teil b der Figur). In der Figur sind die magnetischen Feldlinien 30 eines entsprechenden dauermagnetischen Referenzelementes 29 veranschaulicht. Das Referenzelement 29 wird vorteilhaft so strukturiert, dass die Feldlinien 30 möglichst senkrecht zum Messstrom $I_m$ liegen. Mit einer derartigen Ausbildung der Sensoreinrichtung kann durch den Einsatz des dauermagnetischen Referenzelementes anstatt eines zweiten Leiters eine hohe Kraft bei geringem Energieverbrauch erreicht werden. Auch hier kann der Messstrom $I_m$ durch das Leiterelement 8 weiterverarbeitet werden. Ferner ist eine zu Figur 11 entsprechende Ausgestaltung mit zwei Referenzelementen, zwischen denen das von dem Messstrom $I_m$ durchflossene Leiterelement 8 liegt, möglich.

**Patentansprüche**

1. Sensoreinrichtung (20 bis 24) zur indirekten Strommessung

   a) mit wenigstens einem elektrischen Leiterelement (8), das mittels Stromfluss ein magnetisches Messfeld ($H_m$) erzeugt,
   b) mit mindestens einem Referenzelement (9, 9'), das von dem Leiterelement (8) beabstandet ist und ein magnetisches Referenzfeld ($H_r$) erzeugt, welches mit dem Messfeld ($H_m$) wechselwirkt, sowie
   c) mit wenigstens einem zwischen dem Referenzelement und dem Leiterelement angeordneten Kraftsensor (2, 2'),

      c1) auf den eine von dem Stromfluss abhängende Kraft (k, k') einwirkt,
      c2) der einen magnetostriktiven Teil in Dünnschichttechnik umfasst, der in seiner Ausgangslage ohne Krafteinwirkung bei fehlendem Messfeld ($H_m$)eine vorbestimmte lineare Ausrichtung der Magnetisierung (M2) aufweist, die unter der Kraftwirkung ihre Richtung ändert, und
      c3) der Mittel zur Umwandlung der Richtungsänderung der Magnetisierung (M2') in ein eindeutig damit korreliertes elektrisches Messsignal enthält.

2. Sensoreinrichtung nach Anspruch 1, **dadurch gekennzeichnet, dass** die Umwandlungsmittel wenigstens ein dem magnetostriktiven Teil zugeordnetes magnetoresistives Element sind.

3. Einrichtung nach Anspruch 2, **dadurch gekennzeichnet, dass** die Umwandlungsmittel ein magnetoresistives Mehrschichtensystem (3) sind mit wenigstens einer den magnetostriktiven Teil bildenden Schicht (6).

4. Einrichtung nach Anspruch 2 oder 3, **dadurch gekennzeichnet, dass** das magnetoresistive Element vom AMR- oder vom GMR- oder vom TMR- oder vom XMR-Typ ist.

5. Einrichtung nach einem der Ansprüche 1 oder 2, **dadurch gekennzeichnet, dass** der magnetostriktive Teil des Kraftsensors durch eine magnetoresistive Schicht gebildet ist.

6. Einrichtung nach einem der vorangehenden Ansprüche, **dadurch gekennzeichnet, dass** das Referenzelement (9) und das Leiterelement (8) Teile eines gemeinsamen Leiters sind und entgegengesetzte Stromflussrichtungen aufweisen.

7. Einrichtung nach einem der Ansprüche 1 bis 5, **dadurch gekennzeichnet, dass** das Referenzelement (9) von einem Stromleiter mit entgegengesetzter Stromrichtung gebildet ist, der getrennt vom Stromkreis des Leiterelementes (8) ist.

8. Einrichtung nach einem der Ansprüche 1 bis 5 **dadurch gekennzeichnet, dass** das Referenzelement von einem permanentmagnetischen Element (29) gebildet ist.

9. Einrichtung nach einem der vorangehenden Ansprüche, **dadurch gekennzeichnet, dass** der Kraftsensor zusätzlich in einem magnetischen Hintergrundfeld angeordnet ist.

10. Verwendung der Sensoreinrichtung nach einem der vorangehenden Ansprüche als ein Element der Messtechnik oder der Datenverarbeitung.

11. Verwendung nach Anspruch 10 als digitaler Stromwandler.

12. Verwendung nach Anspruch 10 als Vorstufe zu einem digitalen Logikelement.

**Claims**

1. Sensor device (20 to 24) for indirect current measurement

   a) comprising at least one electrical conductor element (8) which generates a magnetic measurement field ($H_m$) by means of current flow,
   b) comprising at least one reference element (9, 9') which is spaced apart from the conductor element (8) and generates a magnetic reference field ($H_r$) which interacts with the measurement field ($H_m$), and
   c) comprising at least one force sensor (2, 2') which is arranged between the reference element and the conductor element,

   c1) on which a force (k, k') dependent on the current flow acts,
   c2) which comprises a magnetostrictive part using thin-film technology, said part having in its initial position without the action of force, in the absence of a measurement field ($H_m$), a predetermined linear orientation of the magnetization (M2), which changes its direction under the effect of force, and
   c3) which contains means for converting the change in direction of the magnetization (M2') into an electrical measurement signal unambiguously correlated therewith.

2. Sensor device according to Claim 1, **characterized in that** the conversion means are at least one magnetoresistive element assigned to the magnetostrictive part.

3. Device according to Claim 2, **characterized in that** the conversion means are a magnetoresistive multilayer system (3) with at least one layer (6) forming the magnetostrictive part.

4. Device according to Claim 2 or 3, **characterized in that** the magnetoresistive element is of the AMR type or of the GMR type or of the TMR type or of the XMR type.

5. Device according to either of Claims 1 and 2, **characterized in that** the magnetostrictive part of the force sensor is formed by a magnetoresistive layer.

6. Device according to one of the preceding claims, **characterized in that** the reference element (9) and the conductor element (8) are parts of a common conductor and have opposite current flow directions.

7. Device according to one of Claims 1 to 5, **characterized in that** the reference element (9) is formed by a current conductor having an opposite current direction, said current conductor being separate from the electric circuit of the conductor element (8).

8. Device according to one of Claims 1 to 5, **characterized in that** the reference element is formed by a permanent-magnetic element (29).

9. Device according to one of the preceding claims, **characterized in that** the force sensor is additionally arranged in a magnetic background field.

10. Use of the sensor device according to one of the preceding claims as an element appertaining to metrology or appertaining to data processing.

11. Use according to Claim 10 as a digital current converter.

12. Use according to Claim 10 as an input stage with respect to a digital logic element.

**Revendications**

1. Dispositif (20 à 24) de capteur pour mesurer indirectement le courant

   a) comprenant au moins un élément (8) conducteur de l'électricité, qui produit un champ ($H_m$) magnétique de

mesure au moyen d'un flux de courant,

b) comprenant au moins un élément (9, 9') de référence, qui est à distance de l'élément (8) conducteur et qui produit un champ ($H_r$) magnétique de référence, qui interagit avec le champ ($H_m$) de mesure, ainsi que

c) comprenant au moins un capteur (2, 2') de force, disposé entre l'élément de référence et l'élément conducteur,

c1) sur lequel agit une force (k, k') qui dépend du flux de courant,

c2) qui comprend une partie magnétostrictive en technique en couche mince, qui a dans sa position de départ sans action d'une force alors que le champ ($H_m$) de mesure est absent, une direction linéaire déterminée à l'avance de la magnétisation (M2), qui se modifie en direction sous l'effet de la force et

c3) qui comporte des moyens de transformations de la direction de magnétisation (M2') en un signal électrique de mesure ainsi corrélé de manière univoque

2. Dispositif de capteurs suivant la revendication 1, **caractérisé en ce que** les moyens de transformations sont au moins un élément magnétorésistif associé à la partie magnétostrictive.

3. Dispositif de capteur suivant la revendication 2, **caractérisé en ce que** les moyens de transformation sont un système (3) stratifié magnétorésistif ayant au moins une couche (6) formant la partie magnétostrictive.

4. Dispositif de capteur suivant la revendication 2 ou 3, **caractérisé en ce que** l'élément magnétorésistif est du type AMR ou du type GMR ou du type TMR ou du type XMR.

5. Dispositif de capteur suivant l'une des revendications 1 ou 2, **caractérisé en ce que** la partie magnétostrictive du capteur de force est formée par une couche magnétorésistive.

6. Dispositif de capteur suivant l'une des revendications précédentes, **caractérisé en ce que** l'élément (9) de référence et l'élément (8) conducteur font partie d'un conducteur commun et ont des sens de passage du courant opposés.

7. Dispositif de capteur suivant l'une des revendications 1 à 5, **caractérisé en ce que** l'élément (9) de référence est formé par un conducteur de courant, qui a un sens de courant opposé et qui est séparé du circuit de courant de l'élément (8) conducteur.

8. Dispositif de capteur suivant l'une des revendications 1 à 5, **caractérisé en ce que** l'élément de référence est formé par un élément (29) à aimantation permanente.

9. Dispositif de capteur suivant l'une des revendications précédentes, **caractérisé en ce que** le capteur de force est disposé en outre dans un champ de fond magnétique.

10. Utilisation d'un dispositif de capteur selon l'une des revendications précédentes, comme élément de la technique de mesure ou de l'informatique.

11. Utilisation d'un dispositif de capteur selon la revendication 10, comme convertisseur de courant numérique

12. Utilisation d'un dispositif de capteur selon la revendication 10, comme étage d'attaque d'un élément logique numérique.

M2

h

6

5

4

3

2

M1

**FIG 1**

d

6 ( 2 )

M2

8      9

**a )**

6 ( 2 )

k      k

M2'

**b )**

**FIG 2**

FIG 3

a )

b )

FIG 4

a )

b )

FIG 5

a )

b )

**FIG 6**

a )          **FIG 7**          b )

18    2

8    9

21    19

**FIG 8**

$I_m$    $I_r$

6 ( 2 )

8    9

22

**FIG 9**

10

$I_{m1}$    $I_{m2}$

6 ( 2 )

8    9'

11    23

**FIG 10**

FIG 11

$I_{r1}$ $I_m$ $I_{r2}$

24

2 2'

9' 8 9'

$I_m$

29

30 ($H_r$)

25

8

a )

FIG 12

10 30

8

11 29

25

$H_r$

b )

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- EP 0107059 A
- DE 19753554 A1
- US 5686838 A
- EP 0618628 B1
- WO 9415223 A

### In der Beschreibung aufgeführte Nicht-Patentliteratur

- **E. SCHRÜFER.** Elektrische Messtechnik. Hanser-Verlag, 1995, 165-168
- Sensors. VCR-Verlagsgesellschaft, 1989, vol. 5, 145-147
- XMR-Technologien''-Technologieanalyse: Magnetismus. **VDI-TECHNOLOGIEZENTRUM.** VDI-Technologiezentrum. Physikalische Technologien, 1997, vol. 2, 11-46
- *Journal of Magnetism and Magnetic Materials,* 1987, vol. 69, 79-98
- *Journal,* 1989, vol. 79, 358-364